# EUROPEAN PATENT SPECIFICATION

(11) **EP 1 258 034 B1**
(45) Date of publication and mention of the grant of the patent: **26.03.2008**
(21) Application number: 01902922.2
(22) Date of filing: 26.01.2001
(51) Int. Cl.: H01L 21/3063, B81C 1/00, H01L 41/22

(54) **A METHOD FOR PRODUCING A SEMICONDUCTOR DEVICE OF SiC**
VERFAHREN ZUR HERSTELLUNG EINES HALBLEITERBAUELEMENTS AUS SiC
PROCEDE DE PRODUCTION D'UN DISPOSITIF SEMI-CONDUCTEUR EN SiC

(30) Priority: 28.01.2000 SE 0000271
(43) Date of publication of application: 20.11.2002
(73) Proprietor: Cree Sweden AB, 164 40 Kista (SE)
(72) Inventor: HARRIS, Christopher, S-191 72 Sollentuna (SE); KONSTANTINOV, Andrei, S-175 23 Järfälla (SE); ADAS, Christian, 78194 Borlänge (SE); KARLSSON, Stefan, 12566 Järfälla (SE); HÖRMAN, Thomas, S-118 58 Stockholm (SE)
(74) Representative: Olsson, Jan
(86) International application number: PCT/SE2001/000160
(87) International publication number: WO 2001/056069

(56) References cited:
- US-A- 5 445 991
- US-A- 5 500 078
- US-A- 5 674 406
- G.L. HARRIS ET AL.: 'A technique for delineation of PN junction sin cubic silicon carbide' J. ELECTROCHEM. SOC. vol. 135, no. 2, February 1988, pages 405 - 407, XP001108886
- SHOR J.S.: 'Properties of silicon carbide' INSPEC 1995, pages 141 - 149, ISBN 0-85296-870-1, XP002955455

## Description

### TECHNICAL FIELD OF THE INVENTION AND PRIOR ART

The present invention relates to a method for selective etching of SiC.

There is a great demand in for instance the automotive industry for low cost, high temperature pressure sensors that can operate in combustion engines. By accurately monitoring and controlling the pressure in the combustion chamber, the engine efficiency can be raised and the fuel consumption and pollutant emission reduced. To meet these needs, new and innovative pressure sensors for high temperature applications are being developed by various research groups around the world.

It is well known that silicon carbide (SiC) is a useful material for high temperature applications due to its unique properties, such as its wide band gap, high breakdown electric field and high electron saturation drift velocity. Furthermore, SiC exhibits excellent mechanical properties at high temperature, chemical stability and large piezo-resistive coefficients, which makes it suitable for high temperature piezo-resistive sensors. One difficulty in the production of piezo-resistive pressure sensors in SiC is the achievement of a diaphragm having the degree of accuracy necessary for accurate pressure measurements. One method for fabricating SiC-based pressure sensors utilises 3C-SiC films epitaxially grown on Si substrates, which gives a material system that combines the high temperature properties of SiC with methods for the production of diaphragms in Si. A drawback with this material system is that the junction between SiC and Si conducts leakage currents at temperatures around 300°C. Another problem is degradation of the device after a prolonged time due to thermal mismatch effects.

Another newly developed method for producing SiC-based pressure sensors comprises photo electrochemical etching of 6H-SiC. The production process begins with epitaxial growth of p-type 6H-SiC on n-type 6H-SiC wafers, followed by the epitaxial growth of n-type 6H-SiC on the p-type layer. Photo electrochemical etching is used to micromachine the n-type 6H-SiC wafer from the backside into diaphragms and also to pattern the n-type epitaxial 6H-SiC on top into piezo resistors. A drawback of this production method is that the photoelectrochemical etch process directionality is poor, making lateral dimensional control (e.g. of diaphragm size) difficult. Consequently, components produced by this method show a poor repeatability when used for pressure measurements.

Due to its unique properties, SiC is also useful as material for MEMS (micro electro mechanical system) devices of other types than pressure sensors. However, the use of SiC in MEMS applications has been limited due to the fact that it is difficult or even impossible to micromachine and treat this material by means of conventional and known processes for fabrication of for instance Si-MEMS devices. Consequently, there is a great need for an efficient process for machining SiC, allowing the fabrication of MEMS devices of SiC with a high degree of accuracy, and by means of which micro structural devices of SIC having a complex structure may be produced.

A method for selective etching of SiC according to the preamble of appended claim 1 is known through G.L. HARRIS ET AL.: "A technique for delineation of PN junctions in cubic silicon carbide" J. ELECTROCHEM. SOC. Vol. 135, No. 2, February 1988, pages 405-407, XP001108886 (D1).

### SUMMARY OF THE INVENTION

It is an object of the present invention to improve such a method with respect to possible structures which may be obtained thereby.

This object is according to the invention obtained by providing such a method with the features of new claim 1. By carrying out the method on a said multi layer structure with the features of the first, second and third layer, applying the positive potential to the second layer via the first layer and forming a passage in the substrate for allowing the etching solution to come into contact with the second layer, said second layer may be etched in the etching solution for formation of an interspace between the first layer and the third layer for forming a free hanging structure, such as a diaphragm, cantilever or beam, by said third layer. This means that such a structure suitable for for instance MEMS devices of SiC and piezo-resistive pressure sensors of SiC may be formed through this method.

The first p-type layer functions as a means for conducting the necessary current to the second p-type layer, whereas the n-type layer functions as a barrier to the current. Since the first p-type layer has a lower doping concentration than the second p-type layer, the second p-type layer will supply the greater part of the positive charges required for the etching process. During the etching process, the first p-type layer and the third n-type layer will remain almost unaffected by the etching process. Consequently, the etching process will result in a uniform and well defined inter space between the first layer and the third layer.

### BRIEF DESCRIPTION OF THE DRAWING

With reference to the appended drawing, below follows a specific description of a preferred embodiment of the invention cited as examples.

In the drawing:
- Fig 1: is a very schematic cross-section view of a multilayer structure of SiC illustrating the etching principle according to the invention,
- Fig 2-9: are schematic cross-section views illustrating different steps in the fabrication of a SiC piezo-resistive pressure sensor according to a preferred embodiment of the invention.

### DETAILED DESCRIPTION OF A PREFERRED EMBODIMENT OF THE INVENTION

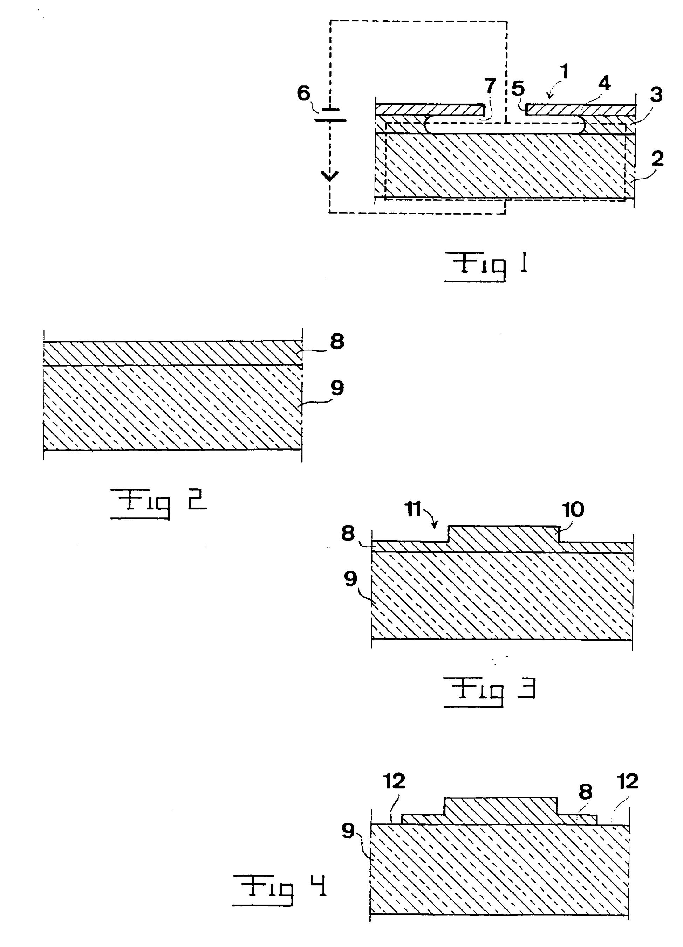

Fig 1 illustrates in a schematic way a method for etching SiC according to the invention. A multilayer structure 1 of SiC, shown in cross-section in Fig 1, comprises a first layer 2 of p-type SiC having a first doping concentration, a second layer 3 of p-type SiC being in contact with the first layer 2 and having a second doping concentration, and a third layer 4 of n-type SiC. The doping concentration of the second p-type layer 3 is higher than the doping concentration of the first p-type layer 2. The second p-type layer 3, which constitutes the p-type layer to be etched, is located between the first p-type layer 2 and the third n-type layer 4. In Fig 1 it is schematically illustrated that an opening 5 is formed in the third layer 4 so as to make it possible to bring the second layer 3 into contact with an etching solution. The first layer 2 is connected to the anode of a source of electric current 6, schematically indicated in Fig 1, and the multi-layer structure 1 is placed in an etching solution containing fluorine ions and having an oxidising effect on SiC. The etching solution is in contact with the cathode. The electric current will flow from the first layer 2 and into the second more conductive layer 3. The third n-type layer 4 forms a barrier to the current and consequently the current will flow from the second layer 3 and into the etching solution. When the current flows from the second layer 3 and into the etching solution, which is in contact with the second layer 3 via the opening 4, the following reactions will take place:

SiC + 60H⁻ + 6e⁺ → SiO₂ + 3H₂O + CO

4HF + SiO₂ → SiF₄ + 2H₂O

In the presence of positive charges (e⁺) SiC will react with the OH ions under formation of a layer of SiO₂. Note that a higher concentration of positive charges will result in faster rate of reaction, hence higher doping concentration will enhance the etch rate. The so formed SiO₂ will then react with fluorine ions resulting in formation of SiF₄, which will be dissolved into the etching solution. Since the second layer 3 of p-type SiC has a higher doping concentration than the first layer, the positive charges required for the etching process will be supplied by the second layer 3 and an etching of this second layer 3 will occur. In Fig 1 it is shown how this etching process has dissolved parts of the second layer 3 leaving an interspace 7 between the first layer 2 and the third layer 4. As long as a current is flowing through the second layer 3 of p-type SiC, this layer supplies the positive charges required for the formation of SiO₂, whereas the first layer 2 of p-type SiC, through which the current flows to the second layer 3, is subjected to a very slow and practically negligible etching. The third n-type layer 4, through which no current will flow, will remain unaffected during the etching process. When the second p-type layer 3 has been etched to a desired extent the supplying of electric current will be cut off and the etching process will stop.

In the example illustrated in Fig 1, the electric current is supplied to the second p-type 3 layer via the first p-type layer 2. This is a convenient way of feeding current to the layer to be etched, since the first p-type layer 2 offers a large contact surface that can easily be connected to a source of electric current. However, the necessary current may be supplied to the p-type layer to be etched in any suitable way, as long as the current is supplied to the p-type layer to be etched via a p-type material being in direct contact with said p-type layer.

The etching solution preferably consists of NH4F mixed with water. However, any solution containing fluorine ions and having an oxidising effect on SiC may be used.

Fig 2-9 show different steps comprised in a method according to the invention for producing a SiC piezo-resistive pressure sensor having a piezo resistor arranged on a diaphragm. In this method the etching process described above is used for formation of the diaphragm. In a first step, see Fig 2, a layer 8 of p-type SiC is epitaxially grown or ion implanted on a substrate 9 of p-type SiC. Said layer 8 being formed with a doping concentration, which is higher than the doping, concentration of the substrate 9.

The p-type layer 8 is subjected to dry etching in order to give the layer a shape that will define the shape of the diaphragm and interspace to be produced. The size of the diaphragm to be formed will depend on the length and the width of the protruding part 10 of the p-type layer 8 formed in this dry etching process. Fig 3 shows the piece 11 after the dry etching process.

In a second dry etching step, etch channels 12 extending through the p-type layer 8 and down to the substrate 9 are formed, as illustrated in Fig 4. The etch channels 12 may as well be arranged to extend a short distance into the substrate 9. These etch channels 12 will later be used for leading the selective etching solution to the p-type layer 8 to be etched in the subsequent electrochemical etching process.

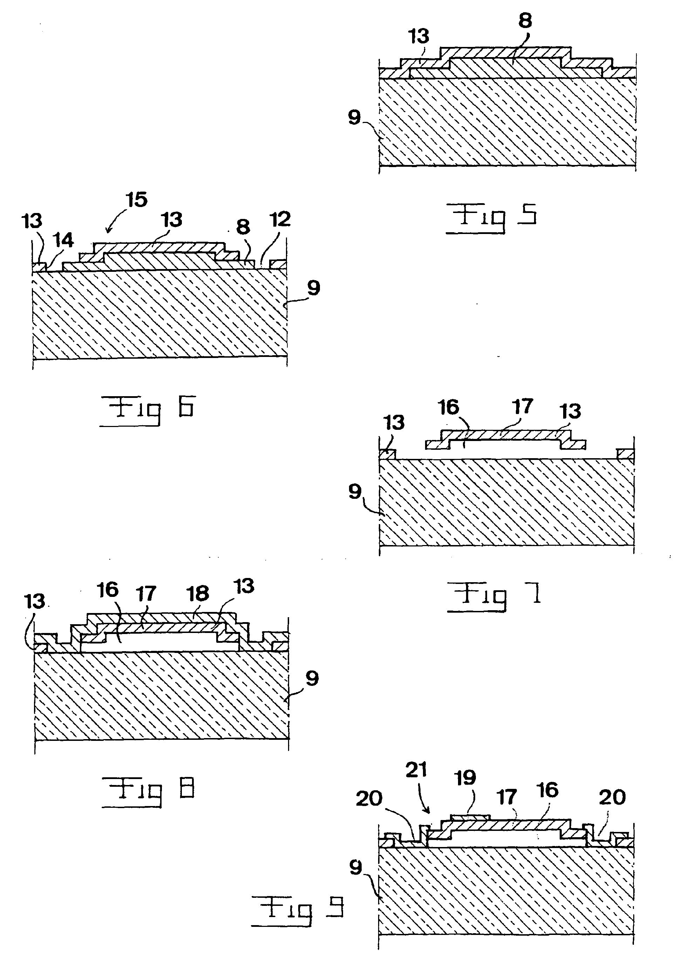

A layer 13 of n-type SiC is thereafter epitaxially grown or ion implanted on top of the p-type layer 8 and the exposed parts of the substrate 9, as illustrated in Fig 5.

The n-type layer 13 is then subjected to a third dry etching step in order to etch away parts of the n-type layer 13 so as to form etch holes 14 reaching down to the previously formed etch channels 12. Between the etch holes 14, parts; not shown, of the n-type layer 13 extending across the etch channels 12 will be left. Via the each holes 14 and the etch channels 12 an etching solution will be able to come into contact with the p-type layer 8. The situation after this third dry etching step is illustrated in Fig 6.

In the next step the so formed piece 15 is placed in a selective etching solution containing fluorine ions and having an oxidising effect on SiC, whereupon a positive potential is applied to the p-type layer 8 via the substrate 9. In accordance with the electrochemical etching process previously described, the p-type layer 8 will be etched, so as to completely remove this layer. When the p-type layer 8 has been etched the electric current being fed to the substrate 9 is cut off so as to avoid slow etching of the substrate 9. Consequently, an interspace in the form of a cavity 16 is formed between the substrate 9 and the n-type layer 13, as illustrated in Fig 7. In this way a diaphragm 17 is formed of the n-type layer 13. The diaphragm 17 is fixed to the substrate 9 by means of the parts, not shown, of the n-type layer 13 extending across the etch channels 12.

In the next step, a new layer 18 of p-type SiC, or a layer of p-type SiC with a subsequent layer of n-type SiC on top or vice versa, is epitaxially grown on the n-type layer 13 and the exposed parts of the substrate 9, as illustrated in Fig 8.

The so formed layer 18 of p-type SiC is then subjected to dry etching in order to form a suitably sized piezo element 19 of p-type SiC on top of the diaphragm 17, and to form a sealing 20 of p-type SiC between the diaphragm 17 and the substrate 9 so as to seal the cavity 16 formed therebetween. High temperature contacts, not shown, are thereafter deposited on the device 21 so as to form means for connecting the piezo element 19 of the so formed pressure sensor to suitable electronic equipment. The diaphragm 17 of n-type SiC will function as a barrier to currents running through the piezo resistor 19 of p-type SiC when the pressure sensor 21 is being used.

Above, a method for the production of pressure sensors has been illustrated. A similar method can of course also be used for producing other types of SiC-MEMS devices having complex microstructure design. The illustrated method can for instance be used for producing SiC accelerometers, in which case no sealing will be formed between the diaphragm and the substrate in the last method step illustrated above. The described method can, of course, also be used for producing SiC-MEMS devices having other types of free hanging structures than diaphragms, e.g. cantilevers or beams. The expression "free hanging structure" here refers to a structure being positioned above an underlying part of the device and supported in at least one point in such a way that an interspace is provided between the structure and said underlying part. Said interspace may for instance contain a fluid or vacuum.

The higher the difference in the doping concentrations between the p-type layer 3,8 to be etched in the electrochemical etching process and the adjacent p-type layer 2,9, the better selectivity in the etching process. Consequently, the best results, i.e. the best selectivity, will be obtained when the p-type layer 3,8 to be etched has a doping concentration which is as high as possible, whereas the substrate 2,9 has a doping concentration which is as low as possible. However, in the example shown, the doping concentration of the substrate 2,9 must be high enough for allowing electric current to flow therethrough. It has been shown that the doping concentration of the p-type layer 3,8 to be etched should be at least 10 times as high as the doping concentration of the underlying substrate 2,9 in order to achieve that in principle only the higher doped layer 3,8 will be etched in the described electrochemical etching process, whereas the substrate 2,9 will remain essentially unaffected. Preferably, the doping concentration of the p-type layer 3,8 to be etched should be at least 100 times as high as the doping concentration of the substrate 2,9. It has also been shown that the doping concentration of the p-type layer 3,8 to be etched should preferably be 10¹⁷ cm⁻³ or higher, whereas the doping concentration of the underlying substrate 2,9 should preferably be 10¹⁶ cm⁻³ or lower.

In the embodiment described above the layers and the substrate are preferably of 6H-SiC, but a semiconductor device could as well be produced of 3C-SiC, 4H-SiC, 15R-SiC or any other polytype of SiC according to the disclosed method. A combination of layers of different types of SiC would also be possible. 6H-SiC is preferred since this material has a high piezo-resistive coefficient and a wider bandgap than 3C-SiC. Furthermore, 6H-SiC can be epitaxially grown with a higher degree of uniformity on etched trenches due to smaller off-axis angle.

The invention is not in any way restricted to the preferred embodiment described above, but many possibilities to modifications thereof would be apparent to a man with ordinary skill in the art without departing from the basic idea of the invention as defined in the appended claims.

The definition layer is to be interpreted broadly and comprises all types of volume extensions and shapes.

"P-type layer" does not exclude the presence of donors in that layer, but the acceptors are in majority. The acceptors used for the p-type layers of SiC may typically be Al or B, whereas N or P is some of the candidates for the donors of the n-type layer.

When a new layer is said to be formed "on" a previous layer by ion implantation it is realized that no new material is added to the structure and that the new layer is formed of material, which before the formation of the new layer constituted an upper part of the previous layer.

## Claims

1. A method for selective etching of SiC, the etching being carried out by applying a positive potential to a layer (3; 8) of p-type SiC being in contact with an etching solution containing fluorine ions and having an oxidising effect on SiC, said layer (3; 8) being part of a multi-layer structure with at least two layers of SiC with different doping concentration and/or different doping type, n and p, so that said etching step results in an etching of said layers to an extent depending upon the nature of doping of the individual layers, **characterized in that** the multi-layer structure comprises a first layer (2; 9) of p-type SiC, a second layer (3; 8) of p-type SiC and a third layer (4; 13) of n-type SiC, the p-type layer to be etched constituting said second layer (3; 8) and being located between the first and the third layer (2, 4; 9, 13), said second layer (3; 8) having a doping concentration which is higher than the doping concentration of the first layer (2; 9), and the positive potential being applied to the second layer (3; 8) via the first layer (2; 9), that a passage (5; 12, 14) is formed in the third layer for allowing the etching solution to come into contact with the second layer (3; 8), and that said second layer (3; 8) is etched in the etching solution for the formation of a cavity (7; 16) between the first layer (2; 9) and the third layer (4; 13), whereby a free hanging structure (17) is formed by said third layer (4; 13).

2. A method according to claim 1, **characterized in that** after the electrochemical etching of the second layer (8), a fourth layer (18) of SiC is formed on the third layer (13) by epitaxial growth or ion implantation, said fourth layer (18) being subjected to etching to form a piezo element (19) of the fourth layer material on the free hanging structure (17) and/or to form a sealing (20) of the fourth layer material between the free hanging structure (17) and the first layer (9) so as to seal the cavity (16) formed between the free hanging structure (17) and the first layer (9).

3. A method according to claim 2, **characterized in that** the second layer is etched so as to form a diaphragm (17) of the third layer (13), and that the fourth layer (18) is etched so as to form a piezo resistor (19) of the fourth layer material on the diaphragm (17) and to form a sealing (20) of the fourth layer material between the diaphragm (17) and the first layer (9) so as to seal the cavity (16) formed between the diaphragm (17) and the first layer (9).

4. A method according to claim 3, **characterized in that** the third layer is formed on the second layer by epitaxial growth, and that before the formation of the third layer (13) on the second layer (8), the second layer (8) is subjected to etching so as to form a protruding part (10) of the second layer material, said protruding part (10) defining the shape of the diaphragm (17).

5. A method according to claim 4, **characterized in that that** the second layer (8) is formed with a doping concentration which is at least ten times as high as the doping concentration of the first layer (9).

6. A method according to claim 5, **characterized in that** the second layer (8) is formed with a doping concentration > 10¹⁷ cm⁻³.

7. A method according to claim 6, **characterized in that** the passage (12, 14) in the third layer (13) is formed by dry etching.

8. A method according to claim 7, **characterized in that** the first layer (9) and/or the second layer (8) and/or the third layer (13) and/or the fourth layer (18) is/are formed of 6H-SiC.

9. A method according to claim 8, **characterized in that** the etching solution consists of a mixture of NH₄F and water.

## Patentansprüche

1. Verfahren zum selektiven Ätzen von SiC, wobei das Ätzen durch Anlegen eines positiven Potenzials an eine Schicht (3; 8) von p-SiC ausgeführt wird, das in Kontakt mit einer Ätzlösung steht, die Fluorionen umfasst und einen oxidierenden Effekt auf SiC aufweist, wobei die Schicht (3; 8) Teil einer Mehrschichtstruktur mit mindestens zwei Schichten SiC mit unterschiedlicher Dotierungskonzentration und/oder unterschiedlichem Dotierungstyp, n und p, ist, so dass der Ätzschritt zu einem Ätzen der Schichten in einem Maße führt, das von der Natur des Dotierens der einzelnen Schichten abhängt, **dadurch gekennzeichnet, dass** die Mehrschichtstruktur eine erste Schicht (2; 9) von p-SiC, eine zweite Schicht (3; 8) von p-SiC und eine dritte Schicht (4; 13) von n-SiC umfasst, wobei die p-Schicht zu Ätzen ist, die die zweite Schicht (3; 8) bildet und sich zwischen der ersten und dritten Schicht (2, 4; 9, 13) befindet, die zweite Schicht (3; 8) eine Dotierungskonzentration aufweist, die höher ist als die Dotierungskonzentration der ersten Schicht (2; 9) und das positive Potenzial an der zweiten Schicht (3; 8) über die erste Schicht (2; 9) angelegt wird, dass ein Durchgang (5; 12, 14) in der dritten Schicht gebildet ist, um zu ermöglichen, dass die Ätzlösung in Kontakt mit der zweiten Schicht (3; 8) kommt und dass die zweite Schicht (3; 8) in der Ätzlösung zur Bildung eines Hohlraums (7; 16) zwischen der ersten Schicht (2; 9) und der dritten Schicht (4; 13) geätzt ist, wobei eine frei hängende Struktur (17) durch die dritte Schicht (4; 13) gebildet ist.

2. Verfahren nach Anspruch 1, **dadurch gekennzeichnet, dass** nach dem elektromechanischen Ätzen der zweiten Schicht (8) eine vierte Schicht (18) von SiC auf der dritten Schicht (13) durch epitaktisches Aufwachsen oder durch Ionenimplantation gebildet wird, wobei die vierte Schicht (18) einem Ätzvorgang unterzogen wird, um ein piezoleketrisches Element (19) aus dem Material der vierten Schicht auf der frei hängenden Struktur (17) zu bilden und/oder eine Dichtung (20) des Materials der vierten Schicht zwischen der frei hängenden Struktur (17) und der ersten Schicht (9) zu bilden, so dass der Hohlraum (16), der zwischen der frei hängenden Struktur (17) und der ersten Schicht (9) gebildet ist, abgedichtet ist.

3. Verfahren nach Anspruch 2, **dadurch gekennzeichnet, dass** die zweite Schicht geätzt ist, so dass sie eine Membran (17) der dritten Schicht (13) bildet, und dass die vierte Schicht (18) geätzt ist, so dass sie einen piezoelektrischen Widerstand (19) des Materials der vierten Schicht auf der Membran (17) bildet und eine Dichtung (20) des Materials der vierten Schicht zwischen der Membran (17) und der ersten Schicht (9) bildet, so dass der Hohlraum (16) abgedichtet ist, der zwischen der Membran (17) und der ersten Schicht (9) gebildet ist.

4. Verfahren nach Anspruch 3, **dadurch gekennzeichnet, dass** die dritte Schicht auf der zweiten Schicht durch epitaktisches Aufwachsen gebildet ist und dass, vor der Bildung der dritten Schicht (13) auf der zweiten Schicht (8), die zweite Schicht (8) einem Ätzvorgang unterzogen wird, so dass ein vorstehender Teil (10) des Materials der zweiten Schicht gebildet wird, wobei der vorstehende Teil (10) die Form der Membran (17) bestimmt.

5. Verfahren nach Anspruch 4, **dadurch gekennzeichnet, dass** die zweite Schicht (8) mit einer Dotierungskonzentration gebildet ist, die mindestens zehnmal so hoch ist, wie die Dotierungskonzentration der ersten Schicht (9).

6. Verfahren nach Anspruch 5, **dadurch gekennzeichnet, dass** die zweite Schicht (8) mit einer Dotierungskonzentration > 10¹⁷ cm⁻³ gebildet ist.

7. Verfahren nach Anspruch 6, **dadurch gekennzeichnet, dass** der Durchgang (12, 14) in der dritten Schicht (13) durch Trockenätzen gebildet ist.

8. Verfahren nach Anspruch 7, **dadurch gekennzeichnet, dass** die erste Schicht (9) und/oder die zweite Schicht (8) und/oder die dritte Schicht (13) und/oder die vierte Schicht (18) aus 6H-SiC gebildet ist/sind.

9. Verfahren nach Anspruch 8, **dadurch gekennzeichnet, dass** die Ätzlösung aus einer Mischung aus NH₄F und Wasser besteht.

## Revendications

1. Procédé d'attaque chimique sélective de SiC, l'attaque étant mise en oeuvre en appliquant un potentiel positif à une couche (3 ; 8) de SiC de type p qui est en contact avec une solution d'attaque contenant des ions fluor et ayant un effet oxydant sur SiC, ladite couche (3 ; 8) faisant partie d'une structure à plusieurs couches ayant au moins deux couches de SiC avec une concentration de dopage différente et/ou un type de dopage différent, n et p, de sorte que ladite étape d'attaque entraîne une attaque desdites couches dans une mesure dépendant de la nature de dopage des couches individuelles,
**caractérisé en ce que** la structure à plusieurs couches comprend une première couche (2 ; 9) de SiC de type p, une deuxième couche (3 ; 8) de SiC de type p et une troisième couche (4 ; 13) de SiC de type n, la couche de type p à graver constituant ladite deuxième couche (3 ; 8) et étant située entre la première couche et la troisième couche (2, 4 ; 9, 13), ladite deuxième couche (3 ; 8) ayant une concentration de dopage qui est supérieure à la concentration de dopage de la première couche (2 ; 9), et le potentiel positif étant appliqué à la deuxième couche (3 ; 8) via la première couche (2 ; 9), **en ce qu'**un passage (5 ; 12, 14) est formé dans la troisième couche pour permettre à la solution d'attaque de venir en contact avec la deuxième couche (3 ; 8), et **en ce que** ladite deuxième couche (3 ; 8) est gravée dans la solution d'attaque pour la réalisation d'une cavité (7 ; 16) entre la première couche (2 ; 9) et la troisième couche (4 ; 13), grâce à quoi une structure avancée libre (17) est formée par ladite troisième couche (4 ; 13).

2. Procédé selon la revendication 1, **caractérisé en ce que**, après l'attaque électrochimique de la deuxième couche (8), une quatrième couche (18) de SiC est formée sur la troisième couche (13) par croissance épitaxiale ou implantation d'ions, ladite quatrième couche (18) étant soumise à une opération d'attaque pour former un élément piézo (19) de la matière de la quatrième couche sur la structure avancée libre (17) et/ou pour former une étanchéité (20) de la matière de la quatrième couche entre la structure avancée libre (17) et la première couche (9) de façon à rendre étanche la cavité (16) formée entre la structure avancée libre (17) et la première couche (9).

3. Procédé selon la revendication 2, **caractérisé en ce que** la deuxième couche est gravée de façon à former un diaphragme (17) de la troisième couche (13), et **en ce que** la quatrième couche (18) est gravée de façon à former une piézo-résistance (19) de la matière de la quatrième couche sur le diaphragme (17) et à former une étanchéité (20) de la matière de la quatrième couche entre le diaphragme (17) et la première couche (9) de façon à rendre étanche la cavité (16) formée entre le diaphragme (17) et la première couche (9).

4. Procédé selon la revendication 3, **caractérisé en ce que** la troisième couche est formée sur la deuxième couche par croissance épitaxiale, et **en ce que**, avant la formation de la troisième couche (13) sur la deuxième couche (8), la deuxième couche (8) est soumise à une attaque de façon à former une partie en saillie (10) de la matière de la deuxième couche, ladite partie en saillie (10) définissant la forme du diaphragme (17).

5. Procédé selon la revendication 4, **caractérisé en ce que** la deuxième couche (8) est formée avec une concentration de dopage qui est au moins dix fois aussi élevée que la concentration de dopage de la première couche (9).

6. Procédé selon la revendication 5, **caractérisé en ce que** la deuxième couche (8) est formée avec une concentration de dopage > à 10¹⁷ cm⁻³.

7. Procédé selon la revendication 6, **caractérisé en ce que** la passage (12, 14) dans la troisième couche (13) est formé par gravure sèche.

8. Procédé selon la revendication 7, **caractérisé en ce que** la première couche (9) et/ou la deuxième couche (8) et/ou la troisième couche (13) et/ou la quatrième couche (18) est/sont formées de 6H-SiC.

9. Procédé selon la revendication 8, **caractérisé en ce que** la solution d'attaque se compose d'un mélange de NH₄F et d'eau.
